# EUROPEAN PATENT APPLICATION

(11) **EP 4 681 864 A1**
(43) Date of publication of application: **21.01.2026**
(21) Application number: 24769792.3
(22) Date of filing: 05.03.2024
(51) Int. Cl.: B23K 31/02, B23K 37/02, B23K 37/04, B21D 7/00, B23P 23/00, B23Q 41/02, H01L 31/18

(54) **BUSBAR WELDING DEVICE, LAYUP AND STITCH-WELDING APPARATUS, AND STITCH-WELDING METHOD**

(30) Priority: 13.03.2023 CN 202310236334
(71) Applicant: Wuxi Autowell Technology Co., Ltd., Wuxi, Jiangsu 214000 (CN)
(72) Inventor: WANG, Heng, Wuxi, Jiangsu 214000 (CN); WANG, Liang, Wuxi, Jiangsu 214000 (CN); MA, Hongwei, Wuxi, Jiangsu 214000 (CN)
(74) Representative: Novagraaf Technologies
(86) International application number: PCT/CN2024/080043
(87) International publication number: WO 2024/188098

(57) **Abstract**

Disclosed are a busbar welding device (10), a layup and stitch-welding apparatus, and a stitch-welding method. The busbar welding device (10) is configured to weld busbars to component units in a cell string assembly, each component unit comprising two cell strings, and a plurality of component units forming the cell string assembly. The busbar welding device (10) comprises a first busbar preparation mechanism (1), a second busbar preparation mechanism (2), a busbar transfer mechanism (3), a first busbar supporting mechanism (4), a second busbar supporting mechanism (5), a third busbar supporting mechanism (6), a stitch-welding gripper (8), and a welding mechanism (7).

## Description

### Technical Field

The present application relates to the field of battery manufacturing, and particularly, to a busbar welding device, a layup and stitch-welding apparatus, and a stitch-welding method.

### Background

A solar cell module is capable of converting solar energy into electrical energy and is currently being increasingly and widely applied. During the manufacturing process of the solar cell module, there is a welding step in which busbars are welded to the extended soldering ribbons of the cell string assembly. To facilitate the subsequent mounting of a junction box, certain busbars need to be bent. The bent ends of the busbars are inserted into the junction box and welded thereto, thereby enabling the current generated by the solar cell module to be output via the junction box. The length and number of the busbars are related to the specifications and number of cell strings included in the cell string assembly.

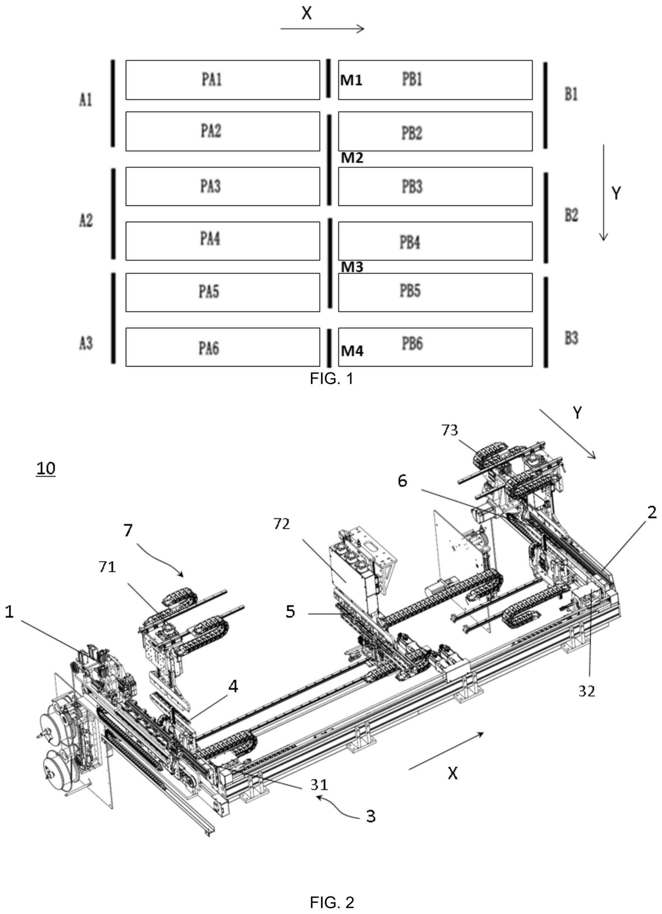

For example, as shown in FIG. 1, when welding a cell string assembly including 6 groups of 12 cell strings, four intermediate busbars are used, i.e., busbars M1, M2, M3, and M4. Busbar M1 is configured to weld cell strings PA1 and PB1; busbar M2 is configured to weld cell strings PA2, PB2, PA3, and PB3; busbar M3 is configured to weld cell strings PA4, PB4, PA5, and PB5; and busbar M4 is configured to weld cell strings PA6 and PB6. The end of busbar M1 proximal to busbar M2 needs to be connected to the junction box and is therefore bent upward, resulting in busbar M1 being approximately L-shaped after bending. Two ends of busbar M2 and busbar M3 require connection to the junction box and are thus bent upward, making busbars M2 and M3 approximately U-shaped after bending. The end of busbar M4 proximal to busbar M3 also needs to be connected to the junction box and is bent upward, with busbar M4 being approximately L-shaped after bending.

In addition, three front-end straight busbars need to be welded to the front end of the cell string assembly, including: busbar A1 for welding the front ends of cell strings PA1 and PA2; busbar A2 for welding the front ends of cell strings PA3 and PA4; and busbar A3 for welding the front ends of cell strings PA5 and PA6. Three rear-end straight busbars also need to be welded to the rear end of the cell string assembly, including: busbar B1 for welding the rear ends of cell strings PB1 and PB2; busbar B2 for welding the rear ends of cell strings PB3 and PB4; and busbar B3 for welding the rear ends of cell strings PB5 and PB6.

At present, a common method for busbar welding is to weld all the busbars on the entire solar cell module at once after the layup of all the cell strings in the cell string assembly has been completed. This welding method requires the busbar welding device to be provided with busbar supporting mechanisms corresponding one-to-one to the busbars to support the busbars during the welding process, and also requires busbar preparation mechanisms to simultaneously prepare all the busbars for welding. In an example of a photovoltaic module including 6 groups of 12 strings as shown in FIG. 1, three straight busbars need to be welded at the front end, three straight busbars at the rear end, and two L-shaped and two U-shaped busbars at the central portion. Correspondingly, ten busbar supporting mechanisms need to be configured, and the busbar preparation mechanisms simultaneously prepare ten busbars, significantly increasing the manufacturing cost and footprint required for the busbar welding device.

### Summary

To solve the technical problems above, the present application provides a busbar welding device, which adopts the following technical solution:
A busbar welding device is configured to weld busbars to component units in a cell string assembly, each component unit including two cell strings disposed in parallel along a first horizontal direction, and a plurality of component units arranged in parallel along a second horizontal direction forming the cell string assembly, the second horizontal direction being perpendicular to the first horizontal direction; and the busbar welding device includes a first busbar preparation mechanism, a second busbar preparation mechanism, a busbar transfer mechanism, a first busbar supporting mechanism, a second busbar supporting mechanism, a third busbar supporting mechanism, a stitch-welding gripper, and a welding mechanism, wherein
the first busbar preparation mechanism is configured to prepare front-end straight busbars, L-shaped bent busbars, and U-shaped bent busbars, and the second busbar preparation mechanism is configured to prepare at least rear-end straight busbars;
the first busbar supporting mechanism, the second busbar supporting mechanism, and the third busbar supporting mechanism are sequentially disposed along the first horizontal direction, wherein the first busbar supporting mechanism is configured to support one front-end straight busbar, the second busbar supporting mechanism is configured to simultaneously support one L-shaped bent busbar and one U-shaped bent busbar, and the third busbar supporting mechanism is configured to support one rear-end straight busbar;
the stitch-welding gripper is configured to pick up the component units and stepwise convey the component units along the second horizontal direction;
the busbar transfer mechanism is configured to pick up a front-end straight busbar from the first busbar preparation mechanism and transfer the front-end straight busbar, which is picked uo, to the first busbar supporting mechanism; and the welding mechanism is configured to, when the component unit to be welded with the front-end straight busbar steps above the first busbar supporting mechanism, weld the front-end straight busbar, supported on the first busbar supporting mechanism, to extended soldering ribbons at a front end of the component unit;
the busbar transfer mechanism is further configured to pick up an L-shaped bent busbar and/or a U-shaped bent busbar from the first busbar preparation mechanism and transfer the L-shaped bent busbar and/or the U-shaped bent busbar, which are picked up, to the second busbar supporting mechanism; and the welding mechanism is further configured to, when the component unit to be welded with the L-shaped bent busbar and/or the U-shaped bent busbar steps above the second busbar supporting mechanism, weld the L-shaped bent busbar and/or U-shaped bent busbar, supported on the second busbar supporting mechanism, to extended soldering ribbons at a central portion of the component unit; and
the busbar transfer mechanism is further configured to pick up a rear-end straight busbar from the second busbar preparation mechanism and transfer the rear-end straight busbar, which is picked up, to the third busbar supporting mechanism; and the welding mechanism is further configured to, when the component unit to be welded with the rear-end straight busbar steps above the third busbar supporting mechanism, weld the rear-end straight busbar, supported on the third busbar supporting mechanism, to extended soldering ribbons at a rear end of the component unit.

The busbar welding device of the present application realizes automatic welding of busbars of the cell string assembly. In particular, by configuring the busbar preparation mechanisms and busbar supporting mechanisms, and by controlling the stitch-welding gripper to stepwise convey the cell string assembly, the busbar welding device of the present application requires only three busbar supporting mechanisms for supporting the busbars to be welded. Before each welding operation, the busbar preparation mechanism only needs to prepare three to four busbars. In the present application, the number of busbar supporting mechanisms and the number of busbars required to be prepared for each welding operation are greatly reduced, thereby lowering device costs and reducing the footprint.

In some embodiments, the first busbar preparation mechanism includes a first straight busbar preparation portion and a first bent busbar preparation portion, and the second busbar preparation mechanism includes at least a second straight busbar preparation portion, wherein the first straight busbar preparation portion and the second straight busbar preparation portion are configured to prepare the front-end straight busbars and the rear-end straight busbars, respectively, and the first bent busbar preparation portion is configured to prepare the L-shaped bent busbars and/or the U-shaped bent busbars.

By configuring the first busbar preparation mechanism and the second busbar preparation mechanism, the first busbar preparation mechanism is capable of preparing front-end straight busbars, L-shaped bent busbars, and U-shaped bent busbars, while the second busbar preparation mechanism is capable of preparing at least rear-end straight busbars.

In some embodiments, the busbar welding device further includes a fourth busbar supporting mechanism disposed between the second busbar supporting mechanism and the third busbar supporting mechanism; the second busbar preparation mechanism further includes a second bent busbar preparation portion which is configured to prepare the L-shaped bent busbars and the U-shaped bent busbars; the busbar transfer mechanism is further configured to pick up an L-shaped bent busbar and/or a U-shaped bent busbar from the second busbar preparation mechanism and transfer the L-shaped bent busbar and/or the U-shaped bent busbar, which are picked up, to the fourth busbar supporting mechanism; and the welding mechanism is further configured to, when the component unit to be welded with the L-shaped bent busbar and/or the U-shaped bent busbar steps above the fourth busbar supporting mechanism, weld the L-shaped bent busbar and/or U-shaped bent busbar, supported on the fourth busbar supporting mechanism, to extended soldering ribbons at the central portion of the component unit.

If all the L-shaped bent busbars and the U-shaped bent busbars at the central portion of the cell string assembly are prepared by the first bent busbar preparation portion and supported by the second busbar supporting mechanism, long waiting times may occur during the welding process, which is detrimental to improving production takt. By providing the fourth busbar supporting mechanism and configuring the second busbar preparation mechanism to be capable of preparing L-shaped bent busbars and U-shaped bent busbars, the preparation speed of the L-shaped bent busbars and U-shaped bent busbars is increased, and the second busbar supporting mechanism and the fourth busbar supporting mechanism can operate alternately, thereby reducing device waiting time and enhancing welding efficiency.

In some embodiments, the first bent busbar preparation portion includes a first feeding assembly, a bending mechanism, and a first cutting mechanism, wherein the first feeding assembly is configured to feed a busbar so that the busbar passes through the first cutting mechanism; and the first cutting mechanism is configured to cut the busbar to obtain a busbar to be bent, and the first feeding assembly is further configured to feed the busbar to be bent to a predetermined position of the bending mechanism; the busbars to be bent are one or two in number; and the bending mechanism is configured to bend one end of the busbar to be bent to obtain the L-shaped bent busbar, and/or to bend two ends of the busbar to be bent to obtain the U-shaped bent busbar; and the busbar transfer mechanism is configured to pick up the L-shaped bent busbar and/or the U-shaped bent busbar from the bending mechanism.

By configuring the first bent busbar preparation portion, the first bent busbar preparation portion is capable of feeding out the busbars from a busbar supply mechanism and performing a press bending operation on the busbars after cutting the busbars, thereby realizing the automatic preparation of the L-shaped bent busbars and/or the U-shaped bent busbars.

In some embodiments, the bending mechanism includes a first mounting base, as well as a first bending assembly, a second bending assembly, a third bending assembly, and a fourth bending assembly sequentially mounted on the first mounting base, wherein the first bending assembly includes a first bending supporting table and a first bending portion disposed on an outer side of the first bending supporting table, the first bending portion being configured to bend upward an end of the busbar to be bent that is supported on the first bending supporting table; the second bending assembly includes a second bending supporting table, a third bending supporting table, and a second bending portion, wherein a first bending gap is maintained between the second bending supporting table and the third bending supporting table, and the second bending portion is configured to bend upward, through the first bending gap, an end of the busbar to be bent that is supported on the second bending supporting table and/or on the third bending supporting table; the third bending assembly includes a fourth bending supporting table, a fifth bending supporting table, and a third bending portion, wherein a second bending gap is maintained between the fourth bending supporting table and the fifth bending supporting table, and the third bending portion is configured to bend upward, through the second bending gap, an end of the busbar to be bent that is supported on the fourth bending supporting table and/or on the fifth bending supporting table; and the fourth bending assembly includes a sixth bending supporting table and a fourth bending portion disposed on an outer side of the sixth bending supporting table, the fourth bending portion being configured to bend upward an end of the busbar to be bent that is supported on the sixth bending supporting table.

By configuring the bending mechanism, the bending mechanism is capable of bending one end of one busbar at a time to prepare one L-shaped bent busbar, or bending two ends of one busbar at a time to prepare one U-shaped bent busbar, or simultaneously bending one end of one busbar and bending two ends of another busbar at a time to simultaneously prepare one L-shaped bent busbar and one U-shaped bent busbar. The mechanism can also prepare L-shaped bent busbars with different bending directions.

In some embodiments, a first slide rail and a locking mechanism are disposed on the first mounting base, the first bending assembly, the second bending assembly, the third bending assembly, and the fourth bending assembly are slidably connected to the first slide rail, and the locking mechanism is configured to lock the first bending assembly, the second bending assembly, the third bending assembly, and the fourth bending assembly on the first slide rail, respectively.

By configuring the first slide rail and the locking mechanism, the bending mechanism is capable of bending the busbars of different lengths, thereby allowing the first bent busbar preparation portion to prepare L-shaped bent busbars and U-shaped bent busbars of different lengths and enhancing the versatility of the first bent busbar preparation portion.

In some embodiments, the second busbar supporting mechanism includes a first lifting drive mechanism, a second mounting base, a first supporting table, a second supporting table, and a third supporting table, wherein the second mounting base is connected to a driving end of the first lifting drive mechanism, and the first lifting drive mechanism is configured to drive the second mounting base to raise and lower; and the first supporting table, the second supporting table, and the third supporting table are sequentially disposed on the second mounting base along the second horizontal direction, wherein the first supporting table and the third supporting table are configured to move toward or away from the second supporting table.

Since the spacing between the L-shaped bent busbar and the U-shaped bent busbar bent simultaneously by the bending mechanism is relatively large, the L-shaped bent busbar and the U-shaped bent busbar need to be brought closer together before welding. By configuring the second busbar supporting mechanism to include a first supporting table, a second supporting table, and a third supporting table, wherein the first supporting table and the third supporting table are capable of moving toward or away from the second supporting table, respectively, the second busbar supporting mechanism can simultaneously support the L-shaped bent busbars and the U-shaped bent busbars, which are prepared, with a large spacing, and adjust the spacing between the L-shaped bent busbars and the U-shaped bent busbars, thereby meeting the welding requirements. In addition, the first lifting drive mechanism is capable of driving the first supporting table, the second supporting table, and the third supporting table to raise synchronously, enabling the L-shaped bent busbars and/or the U-shaped bent busbars to contact the extended soldering ribbons at the central portion of the component units, thereby eliminating the need for the stitch-welding gripper to drive the component units to lower.

**In** some embodiments, the first busbar supporting mechanism and the third busbar supporting mechanism have the same structure, the first busbar supporting mechanism includes a busbar supporting table and a second lifting drive mechanism, the busbar supporting table is connected to a driving end of the second lifting drive mechanism, and the second lifting drive mechanism is configured to drive the busbar supporting table to raise and lower; and the second busbar supporting mechanism further includes a first translational drive mechanism, the first lifting drive mechanism is mounted on a driving end of the first translational drive mechanism, and the first translational drive mechanism is configured to drive the second mounting base to translate along the first horizontal direction.

By configuring the structures of the first busbar supporting mechanism and the third busbar supporting mechanism, the first busbar supporting mechanism and the third busbar supporting mechanism are capable of supporting the front-end straight busbars and the rear-end straight busbars, respectively, and of pushing the front-end straight busbars and the rear-end straight busbars, which are supported, upward onto the extended soldering ribbons at the front ends and the rear ends of the component units, thereby eliminating the need for the stitch-welding gripper to drive the component units to lower. Furthermore, by providing the first translational drive mechanism, the first supporting table, the second supporting table, and the third supporting table are capable of translating toward the first busbar preparation mechanism to receive the L-shaped bent busbars and/or the U-shaped bent busbars transferred from the first busbar preparation mechanism by the busbar transfer mechanism.

In some embodiments, the welding mechanism includes a first welding portion, a second welding portion, and a third welding portion sequentially disposed along the first horizontal direction, wherein the first welding portion is disposed above the first busbar supporting mechanism and is configured to weld the front-end straight busbar, supported on the first busbar supporting mechanism, to the extended soldering ribbons at the front end of the component unit; the second welding portion is disposed above the second busbar supporting mechanism and is configured to weld the L-shaped bent busbar and/or the U-shaped bent busbar, supported on the second busbar supporting mechanism, to the extended soldering ribbons at the central portion of the component unit; and the third welding portion is disposed above the third busbar supporting mechanism and is configured to weld the rear-end straight busbar, supported on the third busbar supporting mechanism, to the extended soldering ribbons at the rear end of the component unit.

By configuring the welding mechanism to include a first welding portion, a second welding portion, and a third welding portion sequentially disposed along the first horizontal direction, the welding mechanism is capable of simultaneously welding the front-end straight busbar, the rear-end straight busbar, and the L-shaped bent busbar and/or the U-shaped bent busbar, thereby enhancing welding efficiency.

In some embodiments, the busbar transfer mechanism includes a first busbar transfer portion and a second busbar transfer portion, wherein the first busbar transfer portion is configured to pick up the front-end straight busbar from the first busbar preparation mechanism and transfer the front-end straight busbar, which is picked up, to the first busbar supporting mechanism; and the first busbar transfer portion is further configured to pick up the L-shaped bent busbar and/or the U-shaped bent busbar from the first busbar preparation mechanism and transfer the L-shaped bent busbar and/or the U-shaped bent busbar, which are picked up, to the second busbar supporting mechanism; and the second busbar transfer portion is configured to pick up the rear-end straight busbar from the second busbar preparation mechanism and transfer the rear-end straight busbar, which is picked up, to the third busbar supporting mechanism.

By configuring the busbar transfer mechanism to include a first busbar transfer portion and a second busbar transfer portion, the transfer efficiency of the busbar transfer mechanism is enhanced.

The present application further provides a layup and stitch-welding apparatus, including a layup pickup portion, an alignment conveying portion, and the busbar welding device according to any one of the aspects above, wherein
the layup pickup portion is disposed upstream of the alignment conveying portion, and the layup pickup portion places at least one component unit onto the alignment conveying portion at predetermined time intervals;
the alignment conveying portion is configured to align the component units placed by the layup pickup portion, and to convey the aligned component units to a string pickup station at predetermined time intervals;
the stitch-welding gripper includes string pickup assemblies disposed in one-to-one correspondence with the component units in the cell string assembly; and the stitch-welding gripper translates along the second horizontal direction to drive the string pickup assemblies corresponding to the component units at the string pickup station to move to the string pickup station for picking up the component units; and
the stitch-welding gripper moves to drive the string pickup assemblies that has picked up the component units to a welding station, and the welding mechanism is configured to weld front-end straight busbars and rear-end straight busbars to front ends and rear ends of the component units located at the welding station, and to weld the L-shaped bent busbars and/or the U-shaped bent busbars to central portions of the component units disposed at the welding station.

The layup and stitch-welding apparatus of the present application integrates the conventional layup machine and stitch-welding machine, thereby saving equipment and processing steps, avoiding a plurality of transfers of the cell strings, ensuring component quality, and reducing equipment costs. Furthermore, it enables synchronous operation of layup and stitch-welding, significantly enhancing the production efficiency of photovoltaic modules. Additionally, the alignment conveying portion steps the component units at predetermined time intervals rather than waiting for all component units to complete layup before conveying, thereby shortening the overall apparatus length and reducing the apparatus footprint.

In some embodiments, the layup and stitch-welding apparatus further includes a jumper preparation portion and a jumper conveying portion, wherein the jumper conveying portion is disposed at a side of the alignment conveying portion and is configured to move synchronously with the alignment conveying portion;
the jumper preparation portion is configured to produce jumpers and place the jumpers onto the jumper conveying portion; and when the alignment conveying portion conveys the component units to the string pickup station, the jumper conveying portion is configured to synchronously convey the jumpers to the string pickup station; and the string pickup assemblies synchronously pick up the component units and the jumpers from the string pickup station, and the welding mechanism is further configured to weld the jumpers.

The layup and stitch-welding apparatus achieves synchronous welding of jumpers and busbars, enabling the layup and stitch-welding apparatus to be compatible with the layup and stitch-welding of photovoltaic modules with jumpers, and enhancing the production efficiency of photovoltaic modules.

The present application further provides a stitch-welding method, which is used to weld busbars to n component units in a cell string assembly, each component unit including two cell strings disposed in parallel along a first horizontal direction, and a plurality of component units disposed in parallel along a second horizontal direction forming the cell string assembly, the second horizontal direction being perpendicular to the first horizontal direction; and the busbars include front-end straight busbars, rear-end straight busbars, L-shaped bent busbars, and U-shaped bent busbars, wherein the L-shaped bent busbars and the U-shaped bent busbars are central busbars; and
the stitch-welding method includes:
stepwise conveying the component units along the second horizontal direction, advancing one or two component units at a time, wherein a welding station is disposed on a stepwise conveying path of the component units, the welding station being capable of simultaneously accommodating at most one front-end straight busbar, one rear-end straight busbar, one L-shaped bent busbar, and one U-shaped bent busbar;
when the component unit to be welded with one front-end straight busbar and one rear-end straight busbar is simultaneously disposed at the welding station, simultaneously welding the front-end straight busbar and the rear-end straight busbar; and
when the component unit to be welded with one L-shaped bent busbar and one U-shaped bent busbar is simultaneously disposed at the welding station, simultaneously welding the L-shaped bent busbar and the U-shaped bent busbar.

The stitch-welding method of the present application, by configuring the welding station and coordinating the stepwise conveyance of the component units, enables staged welding of all busbars to be welded in the cell string assembly. For the front-end straight busbar, only one front-end straight busbar is welded at a time; for the rear-end straight busbar, only one rear-end straight busbar is welded at a time; and for the central busbars, simultaneous welding of one L-shaped bent busbar and one U-shaped bent busbar is achieved. In one aspect, this method simplifies the stitch-welding apparatus and reduces the footprint of the stitch-welding apparatus. In another aspect, the ability to simultaneously weld one L-shaped bent busbar and one U-shaped bent busbar decreases the number of welding operations and enhances the stitch-welding efficiency of photovoltaic modules.

In some embodiments, the stitch-welding method further includes:
when the component unit to be welded with an i-th central busbar steps to the welding station, determining whether a next step causes the component unit to be welded with the i-th central busbar to move away from the welding station, wherein i < n;
if the next step causes the component unit to be welded with the i-th central busbar to move away from the welding station, welding all central busbars disposed at the welding station before the next step;
if the next step does not cause the component unit to be welded with the i-th central busbar to move away from the welding station, waiting for the next step; and
when the component unit to be welded with an n-th central busbar steps to the welding station, welding the n-th central busbar.

Through the determination rules above, the number of welding operations for the central busbars can be reduced by welding two central busbars simultaneously, thereby enhancing welding efficiency.

### Brief Description of the Drawings

FIG. 1 is a schematic structural diagram of a welded cell string assembly according to an embodiment of the present application;
FIG. 2 is a schematic structural diagram of a busbar welding device according to an embodiment of the present application;
FIG. 3 is a schematic structural diagram of a first busbar preparation mechanism according to an embodiment of the present application;
FIG. 4 is a schematic structural diagram of a bending mechanism according to an embodiment of the present application;
FIG. 5 is a schematic diagram of a bending mechanism simultaneously bending one L-shaped bent busbar and one U-shaped bent busbar according to an embodiment of the present application;
FIG. 6 is a schematic structural diagram of a first busbar transfer portion according to an embodiment of the present application;
FIG. 7 is a schematic structural diagram of a second busbar supporting mechanism according to an embodiment of the present application;
FIG. 8 is a schematic structural diagram of a layup and stitch-welding apparatus according to an embodiment of the present application;
FIG. 9 is a schematic structural diagram of a welded cell string assembly according to another embodiment of the present application;
FIG. 10 is a schematic structural diagram of a jumper preparation portion and a jumper conveying portion according to an embodiment of the present application;
FIGS. 11 and 12 are schematic diagrams of a welding process of a first layout of a cell string assembly by a busbar welding device according to an embodiment of the present application;
FIGS. 13 and 14 are schematic diagrams of another welding process of a first layout of a cell string assembly by a busbar welding device according to an embodiment of the present application;
FIGS. 15 and 16 are schematic diagrams of a welding process of a second layout of a cell string assembly by a busbar welding device according to an embodiment of the present application; and
FIG. 17 is a schematic diagram of a welding process of a third layout of a cell string assembly by a busbar welding device according to an embodiment of the present application.
FIGS. 1 to 17 include:
   10. Busbar welding device:
   1. First busbar preparation mechanism:
   11. First straight busbar preparation portion: 111. Second feeding assembly; 112. Tab receiving station; 113. Second cutting mechanism;
   12. First bent busbar preparation portion: 121. First feeding assembly; 122. Bending mechanism; 123. First cutting mechanism; 124. First mounting base; 125. First bending supporting table; 126. First bending portion; 127. Second bending supporting table; 128. Third bending supporting table; 129. Second bending portion; 1210. Fourth bending supporting table; 1211. Fifth bending supporting table; 1212. Third bending portion; 1213. Sixth bending supporting table; 1214. Fourth bending portion; 1215. Pressing portion;
   13. Busbar supply mechanism;
   2. Second busbar preparation mechanism;
   3. Busbar transfer mechanism:
      31. First busbar transfer portion: 311. Translational drive module; 312. Lifting drive module; 313. Busbar pickup portion; 314. First pickup assembly; 315. Second pickup assembly;
      32. Second busbar transfer portion;
      4. First busbar supporting mechanism:
         5. Second busbar supporting mechanism:
         51. First lifting drive mechanism; 52. Second mounting base; MH1. First supporting table; MH2. Second supporting table; MH3. Third supporting table;
         6. Third busbar supporting mechanism:
            7. Welding mechanism:
            71. First welding portion; 72. Second welding portion; 73. Third welding portion;
            8. Stitch-welding gripper;
            20. Layup pickup portion;
            30. Alignment conveying portion;
            40. Jumper preparation portion;
            50. Jumper conveying portion.

### Detailed Description of the Embodiments

To make the objects, features, and advantages above of the present application more apparent and understandable, the present application is further described in detail below with reference to the drawings and specific embodiments.

In the present application, there is provided a busbar welding device, which is configured to weld busbars to component units in a cell string assembly, each component unit including two cell strings disposed in parallel along a first horizontal direction, and a plurality of component units disposed in parallel along a second horizontal direction forming the cell string assembly, the second horizontal direction being perpendicular to the first horizontal direction.

As shown in FIG. 1, the cell string assembly includes six component units, i.e., a first component unit PA1-PB1 including cell strings PA1 and PB1, a second component unit PA2-PB2 including cell strings PA2 and PB3, a third component unit PA3-PB3 including cell strings PA3 and PB3, a fourth component unit PA4-PB4 including cell strings PA4 and PB4, a fifth component unit PA5-PB5 including cell strings PA5 and PB5, and a sixth component unit PA6-PB6 including cell strings PA6 and PB6. Two cell strings in each component unit are disposed in parallel along the first horizontal direction (e.g., the X-axis direction shown in FIG. 1). Six component units are disposed in parallel along the second horizontal direction (e.g., the Y-axis direction shown in FIG. 1) to form a cell string assembly with a layout of 6 groups of 12 strings.

As shown in FIG. 2, the busbar welding device 10 of the present application includes a first busbar preparation mechanism 1, a second busbar preparation mechanism 2, a busbar transfer mechanism 3, a first busbar supporting mechanism 4, a second busbar supporting mechanism 5, a third busbar supporting mechanism 6, a stitch-welding gripper (not shown in FIG. 2), and a welding mechanism 7.

The first busbar preparation mechanism 1 is configured to prepare front-end straight busbars, L-shaped bent busbars, and U-shaped bent busbars, and the second busbar preparation mechanism 2 is configured to prepare at least rear-end straight busbars. The L-shaped bent busbars and the U-shaped bent busbars are central busbars to be welded to extended soldering ribbons at a central portion of the cell string assembly.

The first busbar supporting mechanism 4, the second busbar supporting mechanism 5, and the third busbar supporting mechanism 6 are sequentially disposed along the first horizontal direction (e.g., the X-axis direction shown in FIG. 2), wherein the first busbar supporting mechanism 4 is configured to support one front-end straight busbar, the second busbar supporting mechanism 5 is configured to simultaneously support one L-shaped bent busbar and one U-shaped bent busbar, and the third busbar supporting mechanism 6 is configured to support one rear-end straight busbar.

The stitch-welding gripper is configured to pick up the component units and stepwise convey the component units along the second horizontal direction (e.g., the Y-axis direction shown in FIG. 2).

The busbar transfer mechanism 3 is configured to pick up a front-end straight busbar from the first busbar preparation mechanism 1 and transfer the front-end straight busbar, which is picked up, to the first busbar supporting mechanism 4. The welding mechanism 7 is configured to, when the component unit to be welded with the front-end straight busbar steps above the first busbar supporting mechanism 4, weld the front-end straight busbar, supported on the first busbar supporting mechanism 4, to extended soldering ribbons at a front end of the component unit.

The busbar transfer mechanism 3 is further configured to pick up an L-shaped bent busbar and/or a U-shaped bent busbar from the first busbar preparation mechanism 1 and transfer the L-shaped bent busbar and/or U-shaped bent busbar, which are picked up, to the second busbar supporting mechanism 5. The welding mechanism is further configured to, when the component unit to be welded with the L-shaped bent busbar and/or the U-shaped bent busbar steps above the second busbar supporting mechanism 5, weld the L-shaped bent busbar and/or U-shaped bent busbar, supported on the second busbar supporting mechanism 5, to extended soldering ribbons at a central portion of the component unit.

The busbar transfer mechanism 3 is further configured to pick up a rear-end straight busbar from the second busbar preparation mechanism 2 and transfer the rear-end straight busbar, which is picked up, to the third busbar supporting mechanism 6. The welding mechanism 7 is further configured to, when the component unit to be welded with the rear-end straight busbar steps above the third busbar supporting mechanism 6, weld the rear-end straight busbar, supported on the third busbar supporting mechanism 6, to extended soldering ribbons at a rear end of the component unit.

It can be seen that the busbar welding device 10 of the present application realizes automatic welding of busbars of the cell string assembly. In particular, by configuring the busbar preparation mechanisms and busbar supporting mechanisms, and by controlling the stitch-welding gripper to stepwise convey the cell string assembly, the busbar welding device of the present application requires only three busbar supporting mechanisms for supporting the front-end busbars, central busbars, and rear-end busbars to be welded. Before each welding operation, the busbar preparation mechanism only needs to prepare three to four busbars. Compared to existing busbar welding methods, in the present application, the number of busbar supporting mechanisms and the number of busbars required to be prepared for each welding operation are greatly reduced, thereby lowering device costs and reducing the footprint.

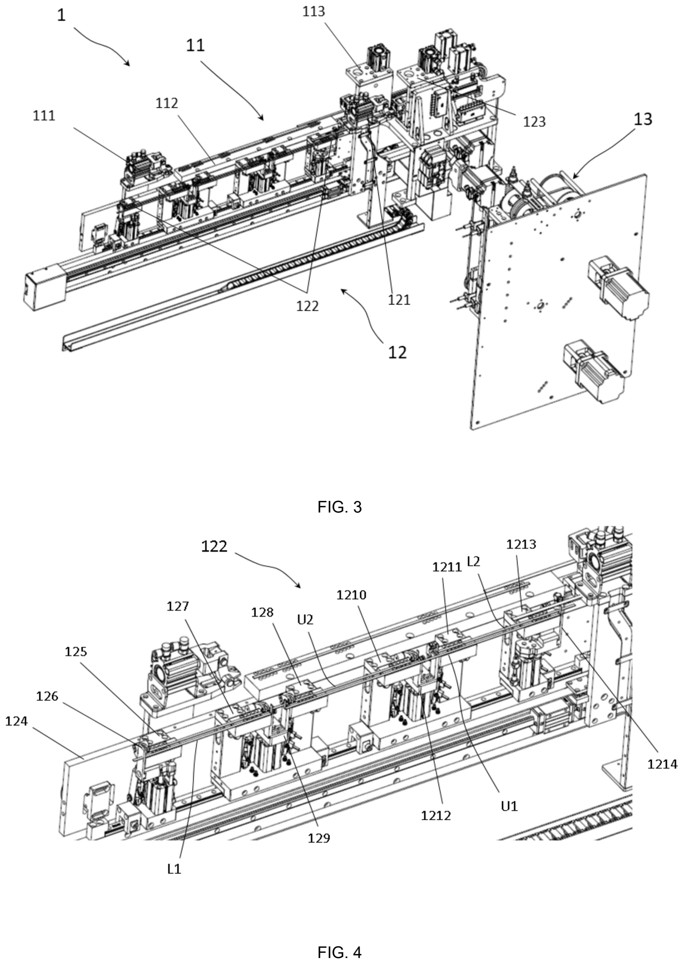

As shown in FIG. 3, optionally, the first busbar preparation mechanism 1 includes a first straight busbar preparation portion 11 and a first bent busbar preparation portion 12, wherein the first straight busbar preparation portion 11 is configured to prepare front-end straight busbars, and the first bent busbar preparation portion 12 is configured to prepare L-shaped bent busbars and/or U-shaped bent busbars. The second busbar preparation mechanism includes at least a second straight busbar preparation portion which is configured to prepare rear-end straight busbars.

Optionally, the first straight busbar preparation portion 11 and the second straight busbar preparation portion have the same structure. In an example of the first straight busbar preparation portion 11, as shown in FIG. 3, the first straight busbar preparation portion 11 includes a second feeding assembly 111, a tab receiving station 112, and a second cutting mechanism 113, wherein the second feeding assembly 111 is configured to feed out a busbar from the busbar supply mechanism 13, so that the busbar passes through the first cutting mechanism 123; and the second cutting mechanism 113 is configured to cut the busbar to obtain one front-end straight busbar. The second feeding assembly 111 is further configured to feed the front-end straight busbar, which is obtained, onto the tab receiving station 112, and the busbar transfer mechanism 3 picks up the front-end straight busbar from the tab receiving station 112.

With continued reference to FIG. 3, optionally, the first bent busbar preparation portion 12 includes a first feeding assembly 121, a bending mechanism 122, and a first cutting mechanism 123, wherein the first feeding assembly 121 is configured to feed out a busbar from the busbar supply mechanism 13, so that the busbar passes through the first cutting mechanism 123; and the first cutting mechanism 123 is configured to cut the busbar to obtain a busbar to be bent. The first feeding assembly 121 is further configured to feed the busbar to be bent to a predetermined position of the bending mechanism 122. The busbars to be bent are one or two in number; and the bending mechanism 122 is configured to bend one end of the busbar to be bent to obtain the L-shaped bent busbar, and/or to bend two ends of the busbar to be bent to obtain the U-shaped bent busbar. The busbar transfer mechanism 3 is configured to pick up the L-shaped bent busbar and/or the U-shaped bent busbar from the bending mechanism 122.

As shown in FIG. 4, optionally, the bending mechanism 122 includes a first mounting base 124, and a first bending assembly, a second bending assembly, a third bending assembly, and a fourth bending assembly sequentially disposed on the first mounting base 124.

**The** first bending assembly includes a first bending supporting table 125 and a first bending portion 126 disposed on an outer side of the first bending supporting table 125, the first bending portion 126 being configured to bend upward an end of a busbar to be bent that is supported on the first bending supporting table.

The second bending assembly includes a second bending supporting table 127, a third bending supporting table 128, and a second bending portion 129, wherein a first bending gap is maintained between the second bending supporting table 127 and the third bending supporting table 128, and the second bending portion 129 is configured to bend upward, through the first bending gap, an end of a busbar to be bent that is supported on the second bending supporting table 127 and/or on the third bending supporting table 128.

The third bending assembly includes a fourth bending supporting table 1210, a fifth bending supporting table 1211, and a third bending portion 1212, wherein a second bending gap is maintained between the fourth bending supporting table 1210 and the fifth bending supporting table 1211, and the third bending portion 1212 is configured to bend upward, through the second bending gap, an end of a busbar to be bent that is supported on the fourth bending supporting table 1210 and/or on the fifth bending supporting table 1211.

The fourth bending assembly includes a sixth bending supporting table 1213 and a fourth bending portion 1214 disposed on an outer side of the sixth bending supporting table 1213, the fourth bending portion 1214 being configured to bend upward an end of a busbar to be bent that is supported on the sixth bending supporting table 1213.

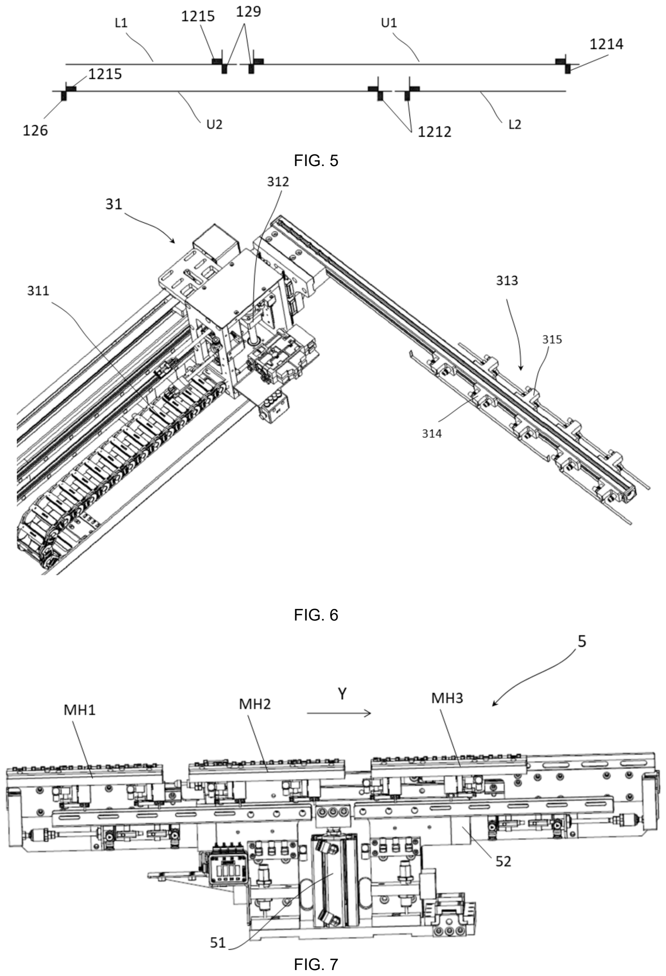

Optionally, as shown in FIG. 5, the first bending supporting table 125, the second bending supporting table 127, the third bending supporting table 128, the fourth bending supporting table 1210, the fifth bending supporting table 1211, and the sixth bending supporting table 1213 are provided with a pressing portion 1215 for pressing the end of the busbar before bending the busbars. Certainly, the pressing portion 1215 may be disposed separately, as long as it can press the end of the busbar before bending.

With continued reference to FIGS. 4 and 5, in one embodiment, the component unit currently disposed above the busbar welding device includes central busbars to be welded, including a front L-shaped bent busbar and a rear U-shaped bent busbar, wherein the length of the L-shaped bent busbar is approximately half the length of the U-shaped bent busbar. The bending process of the bending mechanism 122 is as follows:
The first feeding assembly 121 places the busbar L1 cut by the first cutting mechanism 123 onto the bending mechanism 122, wherein a first end of the busbar L1 is disposed on the first bending supporting table 125 and extends outward beyond the first bending supporting table 125, and a second end of the busbar L1 is disposed on the second bending supporting table 127 and extends outward into the first bending gap. The first feeding assembly 121 places the busbar U1 cut by the first cutting mechanism 123 onto the bending mechanism 122, wherein a first end of the busbar U1 is disposed on the third bending supporting table 128 and extends outward into the first bending gap, and a second end of the busbar U1 is disposed on the sixth bending supporting table 1213 and extends outward beyond the sixth bending supporting table 1213.

Subsequently, the pressing portion 1215 fixes the first end and second end of the busbar L1, as well as the first end and second end of the busbar U1.

Finally, the second bending portion 129 simultaneously bends upward the second end of the busbar L1 and the first end of the busbar U1, while the fourth bending portion 1214 bends upward the second end of the busbar U1, thereby simultaneously obtaining one L-shaped bent busbar and one U-shaped bent busbar.

With continued reference to FIGS. 4 and 5, in another embodiment, the component unit currently disposed above the busbar welding device includes central busbars to be welded, including the U-shaped bent busbar in front and the L-shaped bent busbar in the back, wherein the length of the L-shaped bent busbar is approximately half the length of the U-shaped bent busbar. The bending process of the bending mechanism 122 is as follows:
The first feeding assembly 121 places the busbar U2 cut by the first cutting mechanism 123 onto the bending mechanism 122, wherein a first end of the busbar U2 is disposed on the first bending supporting table 125 and extends outward beyond the first bending supporting table 125, and a second end of the busbar U2 is disposed on the fourth bending supporting table 1210 and extends outward into the second bending gap. The first feeding assembly 121 places the busbar L2 cut by the first cutting mechanism 123 onto the bending mechanism 122, wherein a first end of the busbar L2 is disposed on the fifth bending supporting table 1211 and extends outward into the second bending gap, and a second end of the busbar L2 is disposed on the sixth bending supporting table 1213 and extends outward beyond the sixth bending supporting table 1213.

Subsequently, the pressing portion 1215 fixes the first end and second end of the busbar U2, as well as the first end and second end of the busbar L2.

Finally, the first bending portion 126 bends upward the first end of the busbar U2, while the third bending portion 1212 simultaneously bends upward the second end of the busbar U2 and the first end of the busbar L2, thereby obtaining one U-shaped bent busbar and one L-shaped bent busbar.

From the two embodiments above, it can be seen that the bending mechanism of the present application can not only simultaneously prepare one U-shaped bent busbar and one L-shaped bent busbar, but also prepare L-shaped bent busbars with different bending directions, thereby meeting the preparation requirements for L-shaped bent busbars with different bending directions at two ends of the cell string assembly.

In different embodiments, the lengths of the U-shaped bent busbars and L-shaped bent busbars to be bent may differ. To support and bend busbars to be bent of different lengths, optionally, a first slide rail and a locking mechanism are disposed on the first mounting base 124, the first bending assembly, the second bending assembly, the third bending assembly, and the fourth bending assembly are slidably connected to the first slide rail, and the locking mechanism is configured to lock the first bending assembly, the second bending assembly, the third bending assembly, and the fourth bending assembly on the first slide rail.

By controlling the first bending assembly, the second bending assembly, the third bending assembly, and the fourth bending assembly to slide on the first mounting base 124, the distance between the first bending assembly, the second bending assembly, the third bending assembly, and the fourth bending assembly can be flexibly adjusted. This enables the bending mechanism 122 to support and bend busbars to be bent of different lengths, thereby preparing U-shaped bent busbars and L-shaped bent busbars of different lengths to meet the busbar preparation requirements for photovoltaic modules of different models.

If all the L-shaped bent busbars and U-shaped bent busbars at the central portion of the cell string assembly are prepared by the first bent busbar preparation portion and supported by the second busbar supporting mechanism, long waiting times may occur during the welding process, which is detrimental to improving production takt.

To solve this problem, optionally, the busbar welding device of the present application further includes a fourth busbar supporting mechanism disposed between the second busbar supporting mechanism 5 and the third busbar supporting mechanism 6. The second busbar preparation mechanism 2 further includes a second bent busbar preparation portion which is configured to prepare L-shaped bent busbars and U-shaped bent busbars. That is, in addition to preparing rear-end straight busbars, the second busbar preparation mechanism 2 is also capable of simultaneously preparing L-shaped bent busbars and/or U-shaped bent busbars. Optionally, the second bent busbar preparation portion and the first bent busbar preparation portion have the same structure.

The busbar transfer mechanism 3 is further configured to pick up an L-shaped bent busbar and/or a U-shaped bent busbar from the second busbar preparation mechanism 2 and transfer the L-shaped bent busbar and/or U-shaped bent busbar, which are picked up, to the fourth busbar supporting mechanism.

The welding mechanism 7 is further configured to, when a component unit to be welded with the L-shaped bent busbar and/or the U-shaped bent busbar steps above the fourth busbar supporting mechanism, weld the L-shaped bent busbar and/or U-shaped bent busbar, supported on the fourth busbar supporting mechanism, to extended soldering ribbons at the central portion of the component unit.

By providing the fourth busbar supporting mechanism and configuring the second busbar preparation mechanism to be capable of preparing L-shaped bent busbars and U-shaped bent busbars, the preparation speed of the L-shaped bent busbars and U-shaped bent busbars is increased. The first busbar preparation mechanism and the second busbar preparation mechanism can alternately prepare L-shaped bent busbars and/or U-shaped bent busbars, and the second busbar supporting mechanism and the fourth busbar supporting mechanism can alternately support L-shaped bent busbars and/or U-shaped bent busbars, thereby reducing device waiting time and enhancing welding efficiency.

As shown in FIG. 5, the spacing between the L-shaped bent busbar and the U-shaped bent busbar bent simultaneously by the bending mechanism 122 is relatively large, whereas during welding, the spacing between the L-shaped bent busbar and the U-shaped bent busbar is relatively small. Therefore, it is necessary to adjust the spacing between the L-shaped bent busbar and the U-shaped bent busbar before welding.

To realize the adjustment of the spacing between the L-shaped bent busbar and the U-shaped bent busbar, as shown in FIG. 7, optionally, the second busbar supporting mechanism 5 includes a first lifting drive mechanism 51, a second mounting base 52, a first supporting table MH1, a second supporting table MH2, and a third supporting table MH3, wherein the second mounting base 52 is connected to a driving end of the first lifting drive mechanism 51, and the first lifting drive mechanism 51 is configured to drive the second mounting base 52 to raise and lower. The first supporting table MH1, the second supporting table MH2, and the third supporting table MH3 are sequentially disposed on the second mounting base 52 along the second horizontal direction (e.g., the Y-axis direction shown in FIG. 7), wherein the first supporting table MH1 and the third supporting table MH3 are configured to move toward or away from the second supporting table MH2.

Therefore, the busbar transfer mechanism 3 can pick up the L-shaped bent busbar and the U-shaped bent busbar with a large spacing from the first busbar preparation mechanism 1 and directly place them onto the second busbar supporting mechanism 5, and the second busbar supporting mechanism 5 adjusts the spacing between the L-shaped bent busbar and the U-shaped bent busbar.

For example, when the U-shaped bent busbar is supported on the first supporting table MH1 and the second supporting table MH2, and the L-shaped bent busbar is supported on the third supporting table MH3, the third supporting table MH3 is controlled to slide toward the second supporting table MH2 to reduce the distance between the U-shaped bent busbar and the L-shaped bent busbar.

For another example, when the U-shaped bent busbar is supported on the second supporting table MH2 and the third supporting table MH3, and the L-shaped bent busbar is supported on the first supporting table MH1, the first supporting table MH1 is controlled to slide toward the second supporting table MH2 to reduce the distance between the U-shaped bent busbar and the L-shaped bent busbar.

In addition, since the second mounting base 52 is mounted on the first lifting drive mechanism 51, the first lifting drive mechanism 51 controls the second mounting base 52 to raise, thereby driving the L-shaped bent busbar and/or the U-shaped bent busbar to raise synchronously to contact the extended soldering ribbons at the central portion of the component units, and eliminating the need for the stitch-welding gripper to drive the component units to lower.

Optionally, the second busbar supporting mechanism 5 further includes a first translational drive mechanism, and the first lifting drive mechanism 51 is mounted on a driving end of the first translational drive mechanism. The first translational drive mechanism is configured to drive the second mounting base 52 to translate along the first horizontal direction. This enables the first supporting table MH1, the second supporting table MH2, and the third supporting table MH3 to translate toward the first busbar preparation mechanism 1 to receive L-shaped bent busbars and/or U-shaped bent busbars transferred by the busbar transfer mechanism 3 from the first busbar preparation mechanism 1.

Optionally, the first busbar supporting mechanism 4 and the third busbar supporting mechanism 6 have the same structure. **In** an example of the first busbar supporting mechanism, it includes a busbar supporting table and a second lifting drive mechanism, wherein the busbar supporting table is connected to a driving end of the second lifting drive mechanism, and the second lifting drive mechanism is configured to drive the busbar supporting table to raise and lower. The busbar supporting table is configured to support the front-end straight busbar transferred by the busbar transfer mechanism 3, and the first lifting drive mechanism controls the busbar supporting table to raise, so that the front-end straight busbar contacts the extended soldering ribbons at the front end of the component unit, thereby eliminating the need for the stitch-welding gripper to drive the component units to lower.

With continued reference to FIG. 2, optionally, the welding mechanism 7 includes a first welding portion 71, a second welding portion 72, and a third welding portion 73 sequentially disposed along the first horizontal direction, wherein the first welding portion 71 is disposed above the first busbar supporting mechanism 4 and is configured to weld the front-end straight busbar, supported on the first busbar supporting mechanism 4, to the extended soldering ribbons at the front end of the component unit. The second welding portion 72 is disposed above the second busbar supporting mechanism 5 and is configured to weld the L-shaped bent busbar and/or U-shaped bent busbar, supported on the second busbar supporting mechanism 5, to the extended soldering ribbons at the central portion of the component unit. The third welding portion 73 is disposed above the third busbar supporting mechanism 6 and is configured to weld the rear-end straight busbar, supported on the third busbar supporting mechanism 6, to the extended soldering ribbons at the rear end of the component unit.

By configuring the welding mechanism 7 to include a first welding portion 71, a second welding portion 72, and a third welding portion 73 sequentially disposed along the first horizontal direction, the welding mechanism 7 is capable of simultaneously welding the front-end straight busbar, the rear-end straight busbar, and the L-shaped bent busbar and/or the U-shaped bent busbar, thereby enhancing welding efficiency.

Optionally, the busbar transfer mechanism 3 includes a first busbar transfer portion 31 and a second busbar transfer portion 32, wherein the first busbar transfer portion 31 is configured to pick up the front-end straight busbar from the first busbar preparation mechanism 1 and transfer the front-end straight busbar, which is picked up, to the first busbar supporting mechanism 4. The first busbar transfer portion 31 is further configured to pick up an L-shaped bent busbar and/or a U-shaped bent busbar from the first busbar preparation mechanism 1 and transfer the L-shaped bent busbar and/or U-shaped bent busbar, which are picked up, to the second busbar supporting mechanism 5. The second busbar transfer portion 32 is configured to pick up a rear-end straight busbar from the second busbar preparation mechanism 2 and transfer the rear-end straight busbar, which is picked up, to the third busbar supporting mechanism 6.

As shown in FIG. 6, the first busbar transfer portion 31 includes a translational drive module 311, a lifting drive module 312, and a busbar pickup portion 313, wherein the lifting drive module 312 is connected to a driving end of the translational drive module 311, the busbar pickup portion 313 is connected to a driving end of the lifting drive module 312, and the translational drive module 311 and the lifting drive module 312 are configured to drive the busbar pickup portion 313 to translate and lift, respectively.

The busbar pickup portion 313 includes a first pickup assembly 314 and a second pickup assembly 315, wherein the first pickup assembly 314 is capable of simultaneously picking up one L-shaped bent busbar and one U-shaped bent busbar, and the second pickup assembly 315 is configured to pick up one front-end straight busbar. For example, the first pickup assembly 314 and the second pickup assembly 315 each include a plurality of suction cups disposed in parallel. The number of suction cups on the first pickup assembly 314 is sufficient to simultaneously and stably pick up one L-shaped bent busbar and one U-shaped bent busbar. As shown in FIG. 6, the first pickup assembly 314 includes five suction cups, three of which are configured to pick up the U-shaped bent busbar, and the remaining two are configured to pick up the L-shaped bent busbar. The number of suction cups on the second pickup assembly 315 is sufficient to pick up one straight busbar.

As mentioned in the foregoing embodiments, if the second busbar preparation mechanism 2 is provided with a second bent busbar preparation portion, then the second busbar preparation mechanism 2 is further configured to prepare L-shaped bent busbars and U-shaped bent busbars. Correspondingly, the second busbar transfer portion 32 is required to transfer not only the rear-end straight busbars prepared by the second busbar preparation mechanism 2 but also the L-shaped bent busbars and U-shaped bent busbars prepared by the second busbar preparation mechanism 2. Therefore, in this case, optionally, the second busbar transfer portion 32 may adopt the same structure as the first busbar transfer portion 31 described above.

Certainly, if the second busbar preparation mechanism 2 is solely configured to prepare rear-end straight busbars, then the second busbar transfer portion 32 only needs to transfer the rear-end straight busbars. Therefore, in this case, the second busbar transfer portion 32 may adopt a different structure from the first busbar transfer portion 31 described above, for example, the busbar pickup portion thereof may include only one pickup assembly configured to pick up rear-end straight busbars.

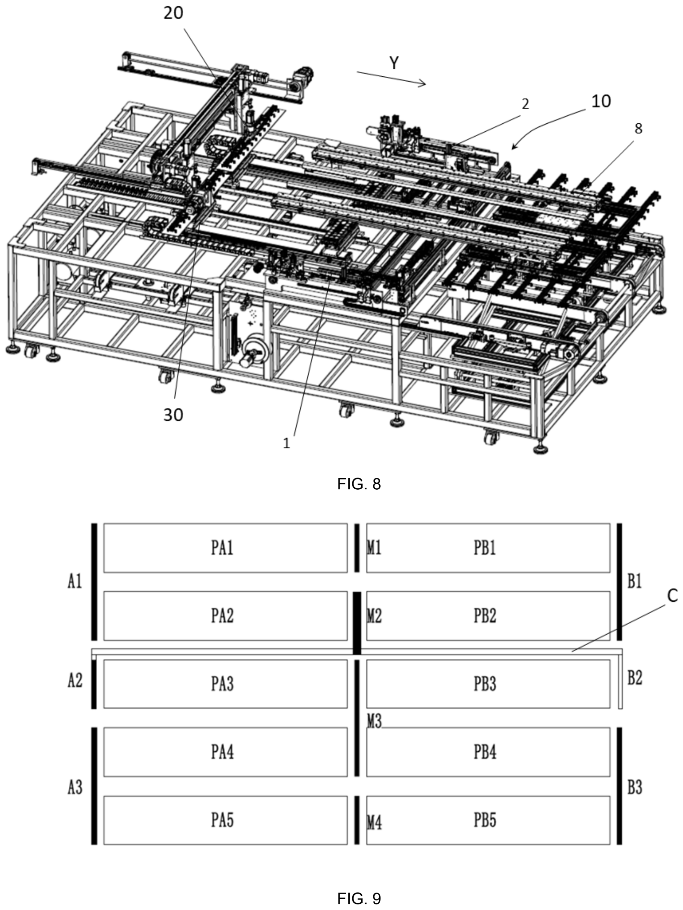

The present application further provides a layup and stitch-welding apparatus. As shown in FIG. 8, the layup and stitch-welding apparatus of the present application includes a layup pickup portion 20, an alignment conveying portion 30, and the busbar welding device 10 according to any one of the embodiments above.

The layup pickup portion 20 is provided upstream of the alignment conveying portion 30, and the layup pickup portion 20 places at least one component unit on the alignment conveying portion 30 at predetermined time intervals.

The alignment conveying portion 30 is configured to align the component units placed by the layup pickup portion, and to convey the aligned component units to a string pickup station at predetermined time intervals.

The stitch-welding gripper 8 of the busbar welding device 10 includes string pickup assemblies disposed in one-to-one correspondence with the component units in the cell string assembly. The stitch-welding gripper 8 translates along the second horizontal direction (e.g., the Y-axis direction shown in FIG. 8) to drive the string pickup assemblies corresponding to the component units at the string pickup station to move to the string pickup station for picking up the component units.

The stitch-welding gripper 8 moves to drive the string pickup assemblies that has picked up the component units to a welding station, and the welding mechanism 7 is configured to weld front-end straight busbars and rear-end straight busbars to front ends and rear ends of the component units disposed at the welding station, and to weld L-shaped bent busbars and/or U-shaped bent busbars to central portions of the component units located at the welding station.

The layup and stitch-welding apparatus of the present application integrates the conventional layup machine and stitch-welding machine, thereby saving equipment and processing steps, avoiding a plurality of transfers of the cell strings, ensuring component quality, and reducing equipment costs. Furthermore, it enables synchronous operation of layup and stitch-welding, significantly enhancing the production efficiency of photovoltaic modules. Additionally, the alignment conveying portion steps the component units at predetermined time intervals rather than waiting for all component units to complete layup before conveying, thereby shortening the overall apparatus length and reducing the apparatus footprint.

Certain layouts of the cell string assembly require welding jumpers. For example, in the cell string assembly including 5 groups of 10 strings shown in FIG. 9, a jumper C is welded between the second component unit PA2-PB2 and the third component unit PA3-PB3. A first end of the jumper C is welded to the busbar A2, a second end of the jumper C is welded to the busbar B2, and a central portion of the jumper C is welded to the busbar M2.

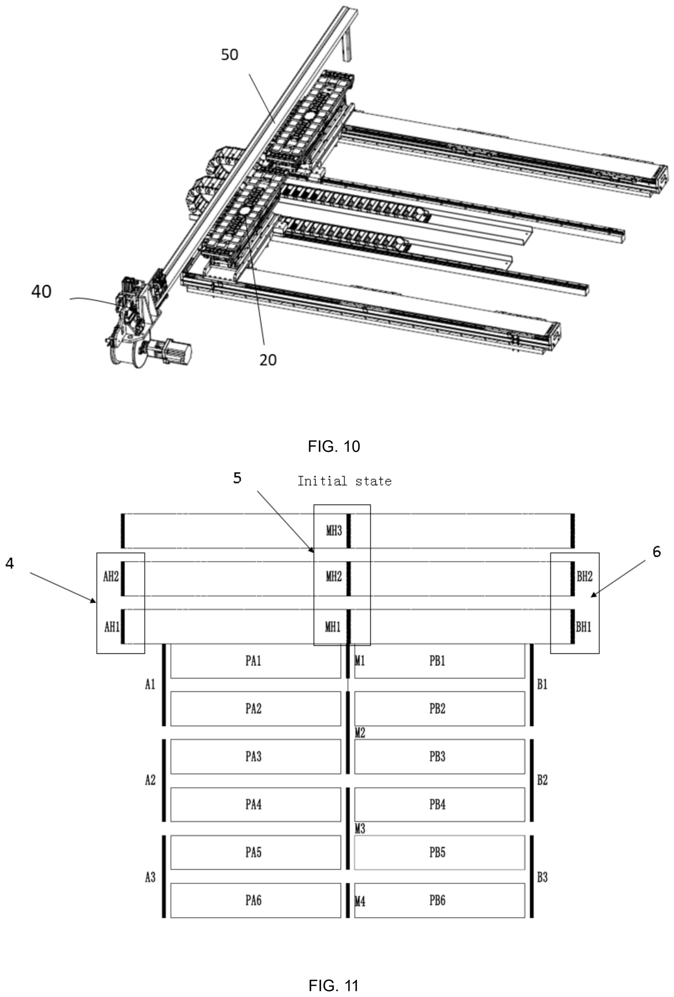

To enable the welding of the jumper C, optionally, as shown in FIG. 10, the layup and stitch-welding apparatus of the present application further includes a jumper preparation portion 40 and a jumper conveying portion 50, wherein the jumper conveying portion 50 is disposed at the side of the alignment conveying portion 20 and is configured to move synchronously with the alignment conveying portion 20. The jumper preparation portion 40 is configured to produce jumpers and place the jumpers onto the jumper conveying portion 50. When the alignment conveying portion 20 conveys the component units to the string pickup station, the jumper conveying portion 50 is configured to synchronously convey the jumpers to the string pickup station. The string pickup assembly synchronously picks up the component units and the jumpers from the string pickup station, and the welding mechanism 7 is further configured to weld the jumpers. It can be seen that the layup and stitch-welding apparatus achieves synchronous welding of jumpers and busbars into the cell string assembly, enabling the layup and stitch-welding apparatus to be compatible with the layup and stitch-welding of photovoltaic modules containing jumpers, and enhancing the production efficiency of photovoltaic modules.

Since the jumper conveying portion and the alignment conveying portion operate in synchronization, the jumper conveying portion and the alignment conveying portion may share the same conveying drive system to simplify the structure and reduce costs.

The present application further provides a stitch-welding method, which is used to weld busbars to n component units in a cell string assembly, each component unit including two cell strings disposed in parallel along a first horizontal direction, and a plurality of component units disposed in parallel along a second horizontal direction forming the cell string assembly, the second horizontal direction being perpendicular to the first horizontal direction. The busbars include front-end straight busbars, rear-end straight busbars, L-shaped bent busbars, and U-shaped bent busbars, wherein the L-shaped bent busbars and the U-shaped bent busbars are central busbars.

The stitch-welding method of the present application can be implemented by the layup and stitch-welding apparatus according to any one of the embodiments above of the present application. In particular, the stitch-welding method of the present application includes:
stepwise conveying the component units along the second horizontal direction, advancing one or two component units at a time, wherein a welding station is disposed on a stepwise conveying path of the component units, the welding station being capable of simultaneously accommodating at most one front-end straight busbar, one rear-end straight busbar, one L-shaped bent busbar, and one U-shaped bent busbar;
when the component unit to be welded with one front-end straight busbar and one rear-end straight busbar is simultaneously disposed at the welding station, simultaneously welding the front-end straight busbar and the rear-end straight busbar; and
when the component unit to be welded with one L-shaped bent busbar and one U-shaped bent busbar is simultaneously disposed at the welding station, simultaneously welding the L-shaped bent busbar and the U-shaped bent busbar.

The stitch-welding method of the present application, by configuring the welding station and coordinating the stepwise conveyance of the component units, enables staged welding of all busbars to be welded in the cell string assembly. For the front-end straight busbar, only one busbar is welded at a time; for the rear-end straight busbar, only one busbar is welded at a time; and for the central busbars, simultaneous welding of one L-shaped bent busbar and one U-shaped bent busbar is achieved. In one aspect, this method simplifies the stitch-welding apparatus and reduces the footprint of the stitch-welding apparatus. In another aspect, the ability to simultaneously weld one L-shaped bent busbar and one U-shaped bent busbar decreases the number of welding operations and enhances the stitch-welding efficiency of photovoltaic modules.

Optionally, when the component unit to be welded with an i-th central busbar steps to the welding station, it is determined whether a next step causes the component unit to be welded with the i-th central busbar to move away from the welding station, wherein i < n.

If the next step causes the component unit to be welded with the i-th central busbar to move away from the welding station, all central busbars disposed at the welding station are welded before the next step. If the next step does not cause the component unit to be welded with the i-th central busbar to move away from the welding station, the process waits for the next step. When the component unit to be welded with an n-th central busbar steps to the welding station, the n-th central busbar is welded.

To enable those skilled in the art to more clearly understand the stitch-welding method of the present application, the specific execution process of the stitch-welding method of the present application is illustratively described below through four embodiments.

### Embodiment 1

This embodiment is used to implement stitch-welding on a cell string assembly with a layout of 6 groups of 12 strings.

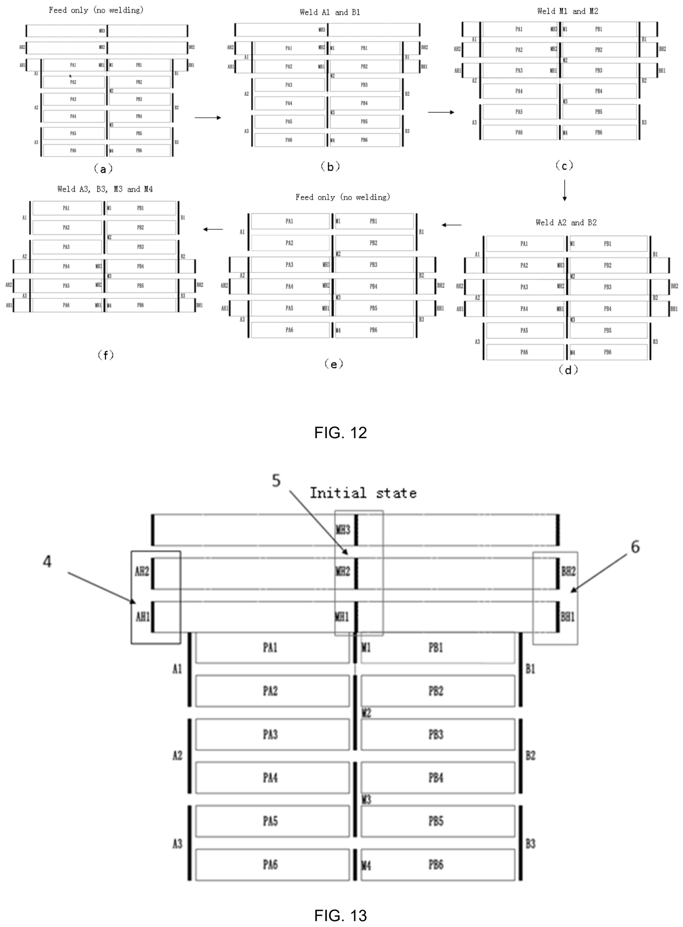

Referring to FIGS. 11 and 12, the stitch-welding process in this embodiment is as follows:
As shown in FIG. 11, a welding station includes a front-end busbar welding station including busbar supporting tables AH1 and AH2, a central busbar welding station including supporting tables MH1, MH2, and MH3, and a rear-end busbar welding station including busbar supporting tables BH1 and BH2.

The busbars to be welded are as follows: A1, A2, and A3 are front-end straight busbars, B1, B2, and B3 are rear-end straight busbars, M1 and M4 are L-shaped bent busbars, and M2 and M3 are U-shaped bent busbars.

In this embodiment, one component unit is stepped forward at a time.

As shown in FIG. 12 (a), the cell string assembly steps forward for the first time. In this case, since the next step does not cause the component unit to be welded with the first central busbar, i.e., the L-shaped bent busbar M1, to move away from the welding station, the process waits for the next step, and the L-shaped bent busbar M1 is not welded at this time, that is, no welding operation is performed.

As shown in FIG. 12 (b), the cell string assembly steps forward for the second time. In this case, the component units PA1-PB1 and PA2-PB2, which are to be welded with the front-end straight busbar A1 and the rear-end straight busbar B1, respectively, step to the front-end busbar welding station and the rear-end busbar welding station, respectively. Therefore, the front-end straight busbar A1 and the rear-end straight busbar B1 are welded simultaneously. Furthermore, since the next step does not cause the component unit to be welded with the L-shaped bent busbar M1 to move away from the welding station, the process waits for the next step, and the L-shaped bent busbar M1 is not welded at this time.

As shown in FIG. 12 (c), the cell string assembly steps forward for the third time. In this case, the component units PA1-PB1, PA2-PB2, and PA3-PB3, which are to be welded with the L-shaped bent busbar M1 and the U-shaped bent busbar M2, are simultaneously positioned at the central busbar welding station. Therefore, the L-shaped bent busbar M1 and the U-shaped bent busbar M2 are welded simultaneously.

As shown in FIG. 12 (d), the cell string assembly steps forward for the fourth time. In this case, the component units PA3-PB3 and PA4-PB4, which are to be welded with the front-end straight busbar A2 and the rear-end straight busbar B2, respectively, step to the front-end busbar welding station and the rear-end busbar welding station, respectively. Therefore, the front-end straight busbar A2 and the rear-end straight busbar B2 are welded simultaneously. Furthermore, since the next step does not cause the component unit to be welded with the third central busbar, i.e., the U-shaped bent busbar M3, to move away from the welding station, the process waits for the next step, and the U-shaped bent busbar M3 is not welded at this time.

As shown in FIG. 12 (e), the cell string assembly steps forward for the fifth time. Since the next step does not cause the component unit to be welded with the third central busbar, i.e., the U-shaped bent busbar M3, to move away from the welding station, the process waits for the next step, and the U-shaped bent busbar M3 is not welded at this time, that is, no welding operation is performed.

As shown in FIG. 12 (f), the cell string assembly steps forward for the sixth time. In this case, the component units PA5-PB5 and PA6-PB6, which are to be welded with the front-end straight busbar A3 and the rear-end straight busbar B3, respectively, step to the front-end busbar welding station and the rear-end busbar welding station, respectively. Moreover, the component units PA4-PB4, PA5-PB5, and PA6-PB6, which are to be welded with the U-shaped bent busbar M3 and the L-shaped bent busbar M4, step to the central busbar welding station. Therefore, the front-end straight busbar A3, the rear-end straight busbar B3, the U-shaped bent busbar M3, and the L-shaped bent busbar M4 are welded simultaneously.

By adopting the stitch-welding method of the present application, for a cell string assembly with a layout of 6 groups of 12 strings, although it steps forward 6 times, only 4 welding operations are required, resulting in high welding efficiency.

### Embodiment 2

This embodiment is used to implement stitch-welding on a cell string assembly with a layout of 6 groups of 12 strings.

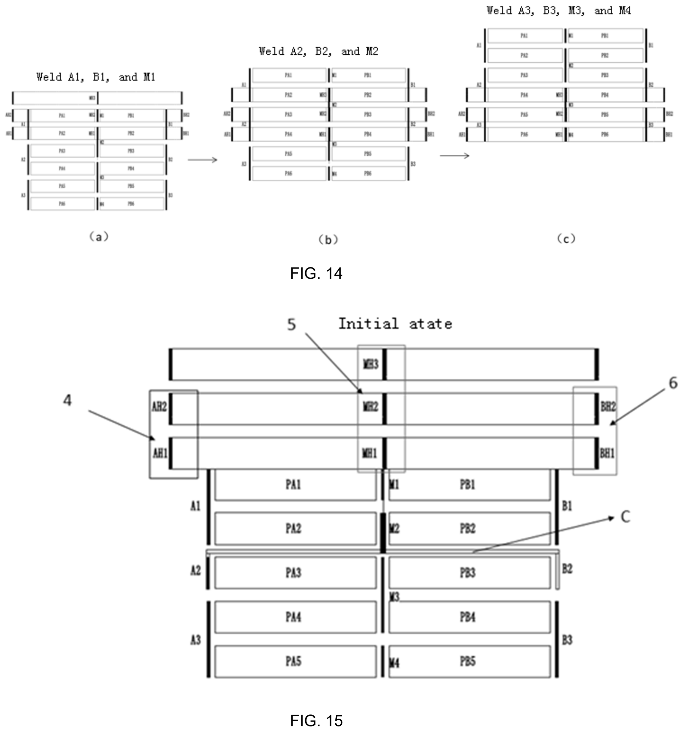

Referring to FIGS. 13 and 14, the stitch-welding process in this embodiment is as follows:
As shown in FIG. 13, a welding station includes a front-end busbar welding station including busbar supporting tables AH1 and AH2, a central busbar welding station including supporting tables MH1, MH2, and MH3, and a rear-end busbar welding station including busbar supporting tables BH1 and BH2.

The busbars to be welded are as follows: A1, A2, and A3 are front-end straight busbars, B1, B2, and B3 are rear-end straight busbars, M1 and M4 are L-shaped bent busbars, and M2 and M3 are U-shaped bent busbars.

In this embodiment, two component units are stepped forward at a time.

As shown in FIG. 14 (a), the cell string assembly steps forward for the first time. In this case, the component units PA1-PB1 and PA2-PB2, which are to be welded with the front-end straight busbar A1 and the rear-end straight busbar B1, respectively, step to the front-end busbar welding station and the rear-end busbar welding station, respectively. Furthermore, since the next step may cause the component unit to be welded with the L-shaped bent busbar M1 to move away from the welding station, the front-end straight busbar A1, the rear-end straight busbar B1, and the L-shaped bent busbar M1 are welded simultaneously.

As shown in FIG. 14 (b), the cell string assembly steps forward for the second time. In this case, the component units PA3-PB3 and PA4-PB4, which are to be welded with the front-end straight busbar A2 and the rear-end straight busbar B2, respectively, step to the front-end busbar welding station and the rear-end busbar welding station, respectively. Furthermore, since the next step may cause the component unit to be welded with the U-shaped bent busbar M2 to move away from the welding station, the front-end straight busbar A2, the rear-end straight busbar B2, and the U-shaped bent busbar M2 are welded simultaneously.

As shown in FIG. 14 (c), the cell string assembly steps forward for the third time. In this case, the component units PA5-PB5 and PA6-PB6, which are to be welded with the front-end straight busbar A3 and the rear-end straight busbar B3, respectively, step to the front-end busbar welding station and the rear-end busbar welding station, respectively. Moreover, the component units PA4-PB4, PA5-PB5, and PA6-PB6, which are to be welded with the U-shaped bent busbar M3 and the L-shaped bent busbar M4, step to the central busbar welding station. Therefore, the front-end straight busbar A3, the rear-end straight busbar B3, the U-shaped bent busbar M3, and the L-shaped bent busbar M4 are welded simultaneously.

By adopting the stitch-welding method of the present application, for a cell string assembly with a layout of 6 groups of 12 strings, although it steps forward 6 times, only 3 welding operations are required, resulting in higher welding efficiency compared to Embodiment 1.

### Embodiment 3

This embodiment is used to implement stitch-welding on a cell string assembly with a layout of 5 groups of 10 strings.

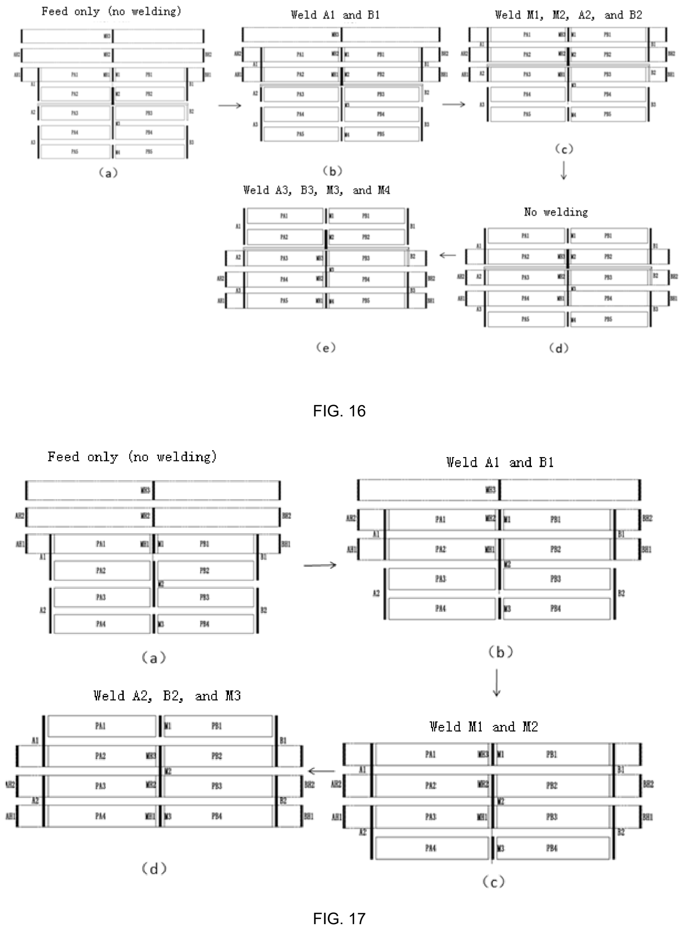

Referring to FIGS. 15 and 16, the stitch-welding process in this embodiment is as follows:
As shown in FIG. 15, a welding station includes a front-end busbar welding station including busbar supporting tables AH1 and AH2, a central busbar welding station including supporting tables MH1, MH2, and MH3, and a rear-end busbar welding station including busbar supporting tables BH1 and BH2.

The busbars to be welded are as follows: A1, A2, and A3 are front-end straight busbars, B1, B2, and B3 are rear-end straight busbars, M1 and M4 are L-shaped bent busbars, and M2 and M3 are U-shaped bent busbars, the length of M2 being approximately half the length of M3.

The jumper C is connected to the component unit PA3-PB3 via the front-end straight busbar A2, the rear-end straight busbar B2, and the U-shaped bent busbar M2.

In this embodiment, one component unit is stepped forward at a time.

As shown in FIG. 16 (a), the cell string assembly steps forward for the first time. In this case, since the next step does not cause the component unit to be welded with the first central busbar, i.e., the L-shaped bent busbar M1, to move away from the welding station, the process waits for the next step, and the L-shaped bent busbar M1 is not welded at this time, that is, no welding operation is performed.

As shown in FIG. 16 (b), the cell string assembly steps forward for the second time. In this case, the component units PA1-PB1 and PA2-PB2, which are to be welded with the front-end straight busbar A1 and the rear-end straight busbar B1, respectively, step to the front-end busbar welding station and the rear-end busbar welding station, respectively. Therefore, the front-end straight busbar A1 and the rear-end straight busbar B1 are welded simultaneously. Furthermore, since the next step does not cause the component unit to be welded with the L-shaped bent busbar M1 to move away from the welding station, the process waits for the next step, and the L-shaped bent busbar M1 is not welded at this time.

As shown in FIG. 16 (c), the cell string assembly steps forward for the third time. In this case, the component unit PA3-PB3, which is to be welded with the front-end straight busbar A2 and the rear-end straight busbar B2, steps to the front-end busbar welding station and the rear-end busbar welding station, respectively. Furthermore, since the next step may cause the component unit to be welded with the L-shaped bent busbar M1 to move away from the welding station, the front-end straight busbar A2, the rear-end straight busbar B2, and all central busbars at the welding station, i.e., the L-shaped bent busbar M1 and the U-shaped bent busbar M2, are welded simultaneously.

As shown in FIG. 16 (d), the cell string assembly steps forward for the fourth time. Since the next step does not cause the component unit to be welded with the third central busbar, i.e., the U-shaped bent busbar M3, to move away from the welding station, the process waits for the next step, and the U-shaped bent busbar M3 is not welded at this time, that is, no welding operation is performed.

As shown in FIG. 16 (e), the cell string assembly steps forward for the fifth time. In this case, PA4-PB5 and PA6-PB6, which are to be welded with the front-end straight busbar A3 and the rear-end straight busbar B3, respectively, step to the front-end busbar welding station and the rear-end busbar welding station, respectively. The component units PA3-PB3, PA4-PB4, and PA5-PB5, which are to be welded with the U-shaped bent busbar M3 and the L-shaped bent busbar M4, step to the central busbar welding station. Therefore, the front-end straight busbar A3, the rear-end straight busbar B3, the U-shaped bent busbar M3, and the L-shaped bent busbar M4 are welded simultaneously.

By adopting the stitch-welding method of the present application, for a cell string assembly with a layout of 5 groups of 10 strings, although it steps forward 5 times, only 3 welding operations are required, resulting in high welding efficiency.

### Embodiment 4

This embodiment is used to implement stitch-welding on a cell string assembly with a layout of 4 groups of 8 strings.

Referring to FIG. 17, the stitch-welding process in this embodiment is as follows:
As shown in FIG. 17 (a), a welding station includes a front-end busbar welding station including busbar supporting tables AH1 and AH2, a central busbar welding station including supporting tables MH1, MH2, and MH3, and a rear-end busbar welding station including busbar supporting tables BH1 and BH2.

The busbars to be welded are as follows: A1 and A2 are front-end straight busbars, B1 and B2 are rear-end straight busbars, M1 and M3 are L-shaped bent busbars, and M2 is a U-shaped bent busbar.

In this embodiment, one component unit is stepped forward at a time.

As shown in FIG. 17 (a), the cell string assembly steps forward for the first time. In this case, since the next step does not cause the component unit to be welded with the first central busbar, i.e., the L-shaped bent busbar M1, to move away from the welding station, the process waits for the next step, and the L-shaped bent busbar M1 is not welded at this time, that is, no welding operation is performed.

As shown in FIG. 17 (b), the cell string assembly steps forward for the second time. In this case, the component units PA1-PB1 and PA2-PB2, which are to be welded with the front-end straight busbar A1 and the rear-end straight busbar B1, respectively, step to the front-end busbar welding station and the rear-end busbar welding station, respectively. Therefore, the front-end straight busbar A1 and the rear-end straight busbar B1 are welded simultaneously. Furthermore, since the next step does not cause the component unit to be welded with the L-shaped bent busbar M1 to move away from the welding station, the process waits for the next step, and the L-shaped bent busbar M1 is not welded at this time.

As shown in FIG. 17 (c), the cell string assembly steps forward for the third time. In this case, the component units PA1-PB1, PA2-PB2, and PA3-PB3, which are to be welded with the L-shaped bent busbar M1 and the U-shaped bent busbar M2, step to the central busbar welding station. Therefore, the L-shaped bent busbar M1 and the U-shaped bent busbar M2 are welded simultaneously.

As shown in FIG. 17 (d), the cell string assembly steps forward for the fourth time. In this case, the component units PA3-PB3 and PA4-PB4, which are to be welded with the front-end straight busbar A2 and the rear-end straight busbar B2, respectively, step to the front-end busbar welding station and the part busbar welding station, respectively. The component unit PA4-PB4, which is to be welded with the L-shaped bent busbar M3, steps to the central busbar welding station. Therefore, the front-end straight busbar A2, the rear-end straight busbar B2, and the L-shaped bent busbar M3 are welded simultaneously.

By adopting the stitch-welding method of the present application, for a cell string assembly with a layout of 4 groups of 8 strings, although it steps forward 4 times, only 3 welding operations are required, resulting in high welding efficiency.

The present application herein has been described in sufficient detail with certain particularity. Those of ordinary skill in the art are to be understand that the descriptions in the embodiments are merely illustrative, and all modifications made without departing from the true spirit and scope of the present application shall fall within the scope of protection of the present application. The scope of protection of the present application is defined by the appended claims and not by the descriptions above in the embodiments.

## Claims

1. A busbar welding device, wherein the busbar welding device is configured to weld busbars to component units in a cell string assembly, each of the component units comprises two cell strings disposed in parallel along a first horizontal direction, and the component units disposed in parallel along a second horizontal direction form the cell string assembly, the second horizontal direction is perpendicular to the first horizontal direction; and the busbar welding device comprises a first busbar preparation mechanism, a second busbar preparation mechanism, a busbar transfer mechanism, a first busbar supporting mechanism, a second busbar supporting mechanism, a third busbar supporting mechanism, a stitch-welding gripper, and a welding mechanism, wherein
the first busbar preparation mechanism is configured to prepare front-end straight busbars, L-shaped bent busbars, and U-shaped bent busbars, and the second busbar preparation mechanism is configured to prepare at least rear-end straight busbars;
the first busbar supporting mechanism, the second busbar supporting mechanism, and the third busbar supporting mechanism are sequentially disposed along the first horizontal direction, wherein the first busbar supporting mechanism is configured to support one front-end straight busbar, the second busbar supporting mechanism is configured to simultaneously support one L-shaped bent busbar and one U-shaped bent busbar, and the third busbar supporting mechanism is configured to support one rear-end straight busbar;
the stitch-welding gripper is configured to pick up the component units and stepwise convey the component units along the second horizontal direction;
the busbar transfer mechanism is configured to pick up one front-end straight busbar from the first busbar preparation mechanism and transfer the front-end straight busbar, which is picked up, to the first busbar supporting mechanism; and the welding mechanism is configured to, when the component unit to be welded with the front-end straight busbar steps above the first busbar supporting mechanism, weld the front-end straight busbar, supported on the first busbar supporting mechanism, to extended soldering ribbons at a front end of the component unit;
the busbar transfer mechanism is further configured to pick up one L-shaped bent busbar and/or one U-shaped bent busbar from the first busbar preparation mechanism and transfer the L-shaped bent busbar and/or the U-shaped bent busbar, which are picked up, to the second busbar supporting mechanism; and the welding mechanism is further configured to, when the component unit to be welded with the L-shaped bent busbar and/or the U-shaped bent busbar steps above the second busbar supporting mechanism, weld the L-shaped bent busbar and/or the U-shaped bent busbar, supported on the second busbar supporting mechanism, to extended soldering ribbons at a central portion of the component unit; and
the busbar transfer mechanism is further configured to pick up one rear-end straight busbar from the second busbar preparation mechanism and transfer the rear-end straight busbar, which is picked up, to the third busbar supporting mechanism; and the welding mechanism is further configured to, when the component unit to be welded with the rear-end straight busbar steps above the third busbar supporting mechanism, weld the rear-end straight busbar, supported on the third busbar supporting mechanism, to extended soldering ribbons at a rear end of the component unit.

2. The busbar welding device according to claim 1, wherein the first busbar preparation mechanism comprises a first straight busbar preparation portion and a first bent busbar preparation portion, and the second busbar preparation mechanism comprises at least a second straight busbar preparation portion, wherein
the first straight busbar preparation portion and the second straight busbar preparation portion are configured to prepare the front-end straight busbars and the rear-end straight busbars, respectively, and the first bent busbar preparation portion is configured to prepare the L-shaped bent busbars and/or the U-shaped bent busbars.

3. The busbar welding device according to claim 2, wherein the busbar welding device further comprises a fourth busbar supporting mechanism disposed between the second busbar supporting mechanism and the third busbar supporting mechanism; the second busbar preparation mechanism further comprises a second bent busbar preparation portion which is configured to prepare the L-shaped bent busbars and the U-shaped bent busbars; the busbar transfer mechanism is further configured to pick up one L-shaped bent busbar and/or one U-shaped bent busbar from the second busbar preparation mechanism and transfer the L-shaped bent busbar and/or the U-shaped bent busbar, which are picked up, to the fourth busbar supporting mechanism; and the welding mechanism is further configured to, when the component unit to be welded with the L-shaped bent busbar and/or the U-shaped bent busbar steps above the fourth busbar supporting mechanism, weld the L-shaped bent busbar and/or the U-shaped bent busbar, supported on the fourth busbar supporting mechanism, to extended soldering ribbons at the central portion of the component unit.

4. The busbar welding device according to claim 2, wherein the first bent busbar preparation portion comprises a first feeding assembly, a bending mechanism, and a first cutting mechanism, wherein
the first feeding assembly is configured to feed a busbar so that the busbar passes through the first cutting mechanism; and the first cutting mechanism is configured to cut the busbar to obtain a busbar to be bent, and the first feeding assembly is further configured to feed the busbar to be bent to a predetermined position of the bending mechanism;
the busbars to be bent are one or two in number; and the bending mechanism is configured to bend one end of the busbar to be bent to obtain the L-shaped bent busbar, and/or to bend two ends of the busbar to be bent to obtain the U-shaped bent busbar; and
the busbar transfer mechanism is configured to pick up the L-shaped bent busbar and/or the U-shaped bent busbar from the bending mechanism.

5. The busbar welding device according to claim 4, wherein the bending mechanism comprises a first mounting base, as well as a first bending assembly, a second bending assembly, a third bending assembly, and a fourth bending assembly sequentially mounted on the first mounting base, wherein
the first bending assembly comprises a first bending supporting table and a first bending portion disposed on an outer side of the first bending supporting table, the first bending portion being configured to bend upward an end of the busbar to be bent that is supported on the first bending supporting table;
the second bending assembly comprises a second bending supporting table, a third bending supporting table, and a second bending portion, wherein a first bending gap is maintained between the second bending supporting table and the third bending supporting table, and the second bending portion is configured to bend upward, through the first bending gap, an end of the busbar to be bent that is supported on the second bending supporting table and/or on the third bending supporting table;
the third bending assembly comprises a fourth bending supporting table, a fifth bending supporting table, and a third bending portion, wherein a second bending gap is maintained between the fourth bending supporting table and the fifth bending supporting table, and the third bending portion is configured to bend upward, through the second bending gap, an end of the busbar to be bent that is supported on the fourth bending supporting table and/or on the fifth bending supporting table; and
the fourth bending assembly comprises a sixth bending supporting table and a fourth bending portion disposed on an outer side of the sixth bending supporting table, the fourth bending portion being configured to bend upward an end of the busbar to be bent that is supported on the sixth bending supporting table.

6. The busbar welding device according to claim 5, wherein a first slide rail and a locking mechanism are disposed on the first mounting base, the first bending assembly, the second bending assembly, the third bending assembly, and the fourth bending assembly are slidably connected to the first slide rail, and the locking mechanism is configured to lock the first bending assembly, the second bending assembly, the third bending assembly, and the fourth bending assembly on the first slide rail, respectively.

7. The busbar welding device according to claim 1, wherein the second busbar supporting mechanism comprises a first lifting drive mechanism, a second mounting base, a first supporting table, a second supporting table, and a third supporting table, wherein
the second mounting base is connected to a driving end of the first lifting drive mechanism, and the first lifting drive mechanism is configured to drive the second mounting base to raise and lower; and
the first supporting table, the second supporting table, and the third supporting table are sequentially disposed on the second mounting base along the second horizontal direction, wherein the first supporting table and the third supporting table are configured to move toward or away from the second supporting table.

8. The busbar welding device according to claim 7, wherein
the first busbar supporting mechanism and the third busbar supporting mechanism have the same structure, the first busbar supporting mechanism comprises a busbar supporting table and a second lifting drive mechanism, the busbar supporting table is connected to a driving end of the second lifting drive mechanism, and the second lifting drive mechanism is configured to drive the busbar supporting table to raise and lower; and
the second busbar supporting mechanism further comprises a first translational drive mechanism, the first lifting drive mechanism is mounted on a driving end of the first translational drive mechanism, and the first translational drive mechanism is configured to drive the second mounting base to translate along the first horizontal direction.

9. The busbar welding device according to claim 1, wherein the welding mechanism comprises a first welding portion, a second welding portion, and a third welding portion sequentially disposed along the first horizontal direction, wherein
the first welding portion is disposed above the first busbar supporting mechanism and is configured to weld the front-end straight busbar, supported on the first busbar supporting mechanism, to the extended soldering ribbons at the front end of the component unit;
the second welding portion is disposed above the second busbar supporting mechanism and is configured to weld the L-shaped bent busbar and/or the U-shaped bent busbar, supported on the second busbar supporting mechanism, to the extended soldering ribbons at the central portion of the component unit; and
the third welding portion is disposed above the third busbar supporting mechanism and is configured to weld the rear-end straight busbar, supported on the third busbar supporting mechanism, to the extended soldering ribbons at the rear end of the component unit.

10. **The** busbar welding device according to claim 1, wherein the busbar transfer mechanism comprises a first busbar transfer portion and a second busbar transfer portion, wherein
the first busbar transfer portion is configured to pick up the front-end straight busbar from the first busbar preparation mechanism and transfer the front-end straight busbar, which is picked up, to the first busbar supporting mechanism; and the first busbar transfer portion is further configured to pick up the L-shaped bent busbar and/or the U-shaped bent busbar from the first busbar preparation mechanism and transfer the L-shaped bent busbaror the U-shaped bent busbar, which are picked up, to the second busbar supporting mechanism; and
the second busbar transfer portion is configured to pick up the rear-end straight busbar from the second busbar preparation mechanism and transfer the rear-end straight busbar, which is picked up, to the third busbar supporting mechanism.

11. A layup and stitch-welding apparatus, comprising a layup pickup portion, an alignment conveying portion, and the busbar welding device according to claims 1 to 10, wherein
the layup pickup portion is disposed upstream of the alignment conveying portion, and the layup pickup portion places at least one component unit onto the alignment conveying portion at predetermined time intervals;
the alignment conveying portion is configured to align the component units placed by the layup pickup portion, and to convey the aligned component units to a string pickup station at predetermined time intervals;
the stitch-welding gripper comprises string pickup assemblies disposed in one-to-one correspondence with the component units in the cell string assembly; and the stitch-welding gripper translates along the second horizontal direction to drive the string pickup assemblies corresponding to the component units at the string pickup station to move to the string pickup station for picking up the component units; and
the stitch-welding gripper moves to drive the string pickup assemblies that has picked up the component units to a welding station, and the welding mechanism is configured to weld front-end straight busbars and rear-end straight busbars to front ends and rear ends of the component units located at the welding station, and to weld the L-shaped bent busbars and/or the U-shaped bent busbars to central portions of the component units disposed at the welding station.

12. The layup and stitch-welding apparatus according to claim 11, further comprising a jumper preparation portion and a jumper conveying portion, wherein
the jumper conveying portion is disposed at a side of the alignment conveying portion and is configured to move synchronously with the alignment conveying portion;
the jumper preparation portion is configured to produce jumpers and place the jumpers onto the jumper conveying portion; and when the alignment conveying portion conveys the component units to the string pickup station, the jumper conveying portion is configured to synchronously convey the jumpers to the string pickup station; and
the string pickup assemblies synchronously pick up the component units and the jumpers from the string pickup station, and the welding mechanism is further configured to weld the jumpers.

13. A stitch-welding method, wherein the stitch-welding method is used to weld busbars to n component units in a cell string assembly, each component unit comprising two cell strings disposed in parallel along a first horizontal direction, and a plurality of component units disposed in parallel along a second horizontal direction forming the cell string assembly, the second horizontal direction being perpendicular to the first horizontal direction; and the busbars comprise front-end straight busbars, rear-end straight busbars, L-shaped bent busbars, and U-shaped bent busbars, wherein the L-shaped bent busbars and the U-shaped bent busbars are central busbars; and
the stitch-welding method comprises:
stepwise conveying the component units along the second horizontal direction, advancing one or two component units at a time, wherein a welding station is disposed on a stepwise conveying path of the component units, the welding station being capable of simultaneously accommodating at most one front-end straight busbar, one rear-end straight busbar, one L-shaped bent busbar, and one U-shaped bent busbar;
when the component unit to be welded with one front-end straight busbar and one rear-end straight busbar is simultaneously disposed at the welding station, simultaneously welding the front-end straight busbar and the rear-end straight busbar; and
when the component unit to be welded with one L-shaped bent busbar and one U-shaped bent busbar is simultaneously disposed at the welding station, simultaneously welding the L-shaped bent busbar and the U-shaped bent busbar.

14. The stitch-welding method according to claim 13, further comprising:
when the component unit to be welded with an i-th central busbar steps to the welding station, determining whether a next step causes the component unit to be welded with the i-th central busbar to move away from the welding station, wherein i < n;
if the next step causes the component unit to be welded with the i-th central busbar to move away from the welding station, welding all central busbars disposed at the welding station before the next step;
if the next step does not cause the component unit to be welded with the i-th central busbar to move away from the welding station, waiting for the next step; and
when the component unit to be welded with an n-th central busbar steps to the welding station, welding the n-th central busbar.
